Europäisches Patentamt

European Patent Office

Office européen des brevets

(11) Publication number: **0 007 781**
**A1**

## EUROPEAN PATENT APPLICATION

(21) Application number: **79301438.2**

(22) Date of filing: **19.07.79**

(51) Int. Cl.³: **G 05 F 1/12**
**H 03 G 3/20, H 03 F 1/52**
**H 01 F 19/02**

(30) Priority: **20.07.78 GB 3055278**

(43) Date of publication of application:
**06.02.80 Bulletin 80/3**

(84) Designated Contracting States:
**DE**

(71) Applicant: **THE RANK ORGANISATION LIMITED**
**11 Hill Street**
**London W1X 8AE(GB)**

(72) Inventor: **Kummel, Winfried**
**Saalburgstrasse 15**
**D-6380 Bad Homburg v.d.H.(DE)**

(74) Representative: **Cullis, Roger et al,**
**c/o H.G. Amann, Patents Manager 439 Godstone Road**
**Whyteleafe Surrey, CR3 0YG(GB)**

(54) Method and apparatus for controlling the current supplied to a load.

(57) The invention concerns a method of controlling the current supplied by a current source to a load. The current is supplied to the load 12 via a first conductor 11 from the current source 10 and the current in the first conductor 11 is monitored by a second conductor 13 disposed alongside the first so that a current is induced in the second conductor 13 which is proportional to the current in the first conductor 11. The signal in the second conductor 13 is fed back to control the supply of current by the current source 10 in dependence upon the behaviour of the induced signal.

The invention is applicable to the short circuit protection of amplifier end stages and the control of loudspeaker amplifiers in the resonance frequency region.

Fig. 1.

- 1 -

Controlling the Current Supplied to a Load

This invention relates to a method of controlling the current supplied by a current source to a load, and is applicable to the short circuit protection of amplifier end stages and the control of loudspeaker amplifiers in the resonance frequency region.

Conventional protective circuits for amplifier final stages are only practicable up to medium power outputs. For amplifier outputs of 200 Watts, 500 Watts and above, the conventional circuits are no longer sufficiently rapid in response, and they mostly possess the property that the final stages must be regulated down to a so-called 'safe value'. Nevertheless in such cases substantial currents still flow and the resulting dissipated heat is very high. In the case of long persisting short circuit conditions, the final transistors are usually damaged (due to thermal instability) or else they oscillate in the HF region and thus disturb, for example, a connected loudspeaker system. In the limiting case, that is to say in the case of a short circuit of the medium ohmic class, the protection is not at all effective and adjustment of the electronic circuitry is very critical and in most cases must be separately effected for both halves of the final stage. In the case of final stages in push-pull circuit the electronic circuitry is already very expensive. Thus it is an object of the invention to provide a method of controlling the current supplied by a current source to a load, the control being rapidly effective in response to a predetermined behaviour

- 2 -

of the current.

Accordingly the invention provides a method of controlling the current supplied by a current source through a first conductor to a load, wherein the current in the first conductor is monitored by a second conductor disposed alongside the first so that a current is induced in the second conductor which is proportional to the current in the first conductor, and the supply of current by the current source is controlled in dependence upon the behaviour of the current induced in the second conductor.

Embodiments of the invention will now be described, by way of example, with reference to the accompanying drawings, in which:

FIGURE 1 is a schematic circuit diagram illustrating the principles on which the invention is based, and

FIGURES 2 to 4 are schematic diagrams of respective control circuits embodying the invention.

The invention is based upon the fact that an electromagnetic field is formed around any conductor carrying an electric current. Thus, if a second conductor is laid alongside the first, a current is induced in the second conductor which is proportional to the current in the first conductor.

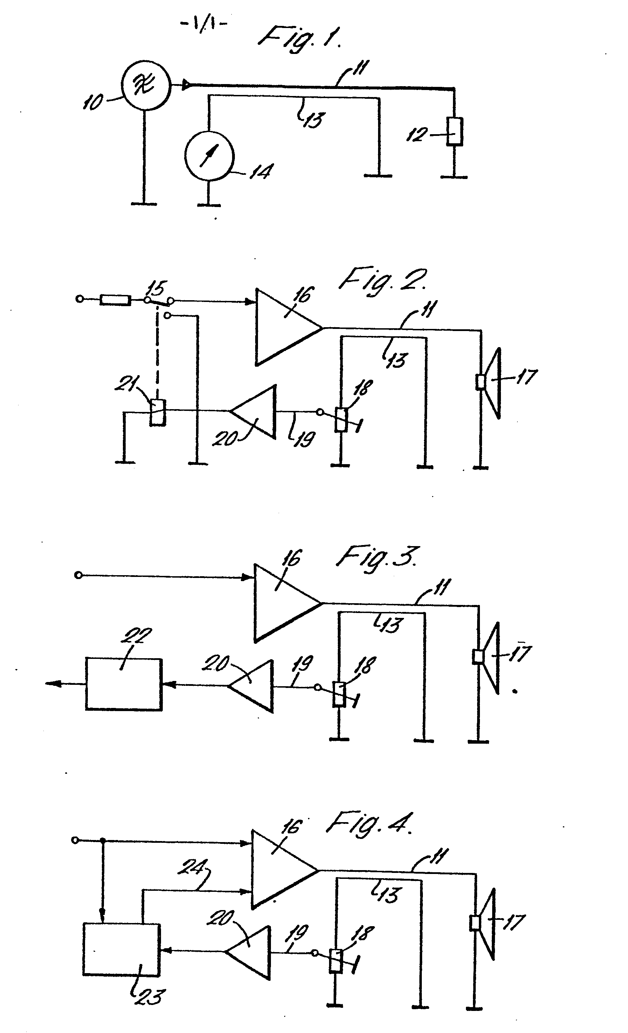

This principle is shown in FIGURE 1. A current source 10, such as a generator or amplifier, supplies current through a main conductor 11 to a load 12 such as a resistor, motor or loudspeaker. An auxiliary conductor 13 is disposed alongside the main conductor 11 for a distance of, for example, ten centimetres. The current induced in the conductor 13 and measured by the meter 14 is directly proportional to the current in the main conductor 11, and can be used to derive a feed back signal to provide a variety of control functions of the current source 10. The conductors 11 and 13 may be wires, Litz cables or other conductors, or the conductor 13 may be the inner conductor of a screened cable if the outer conductor of the cable is used as the conductive connection 11 between the generator or amplifier 10 and the load 12.

Various practical control applications using the above principle are shown in FIGURES 2 to 4.

In FIGURE 2 an audio signal is applied through an electric switch or relay 15, which is normally in its upper position shown, to the input of a power amplifier 16 corresponding to the current source 10 of FIGURE 1. The amplifier output is supplied via a main conductor 11 to a loudspeaker 17 corresponding to the load 12 of FIGURE 1. The current supplied to the loudspeaker 17 is monitored by the auxiliary conductor 13, and when the current induced in 13 exceeds a preselected value determined by a variable threshold device 18, the latter provides a feedback signal

- 4 -

on line 19. The signal on line 19 is amplified in the operational amplifier 20 and after rectification is used to energise the winding 21 of the relay 15. The relay contact thus assumes its lower position and the audio signal is diverted to earth. In this way the input signal can be rapidly disconnected from the amplifier 16 when a potentially damaging overload of the loudspeaker 17 or amplifier 16 would otherwise occur. Other switching operations can also be performed.

In FIGURE 3, which in many respects is the same as FIGURE 2, the amplified signal from 20 is not used to disconnect the input signal from the amplifier 16, but instead is used to disconnect the supply voltage from the amplifier. Thus the signal from 20 is supplied to a Schmitt Trigger 22 which in turn supplies a switching signal to the electronically stabilised mains section (not shown) of the circuit. The effect of the switching signal is to cut off the mains supply to the amplifier 16, and this can be achieved in known manner, for example, by the use of a relay. This FIGURE 3 circuit could be used, for example, to prevent damage to the amplifier under short circuit conditions.

A basic difference between the circuits of FIGURES 2 and 3 is that in the former the input signal is only temporarily diverted to ground, during the periods of potential overload, so that the circuit automatically resets itself upon disappearance of the overload condition and normal operation resumes. In FIGURE 3, however,

- 5 -

the reconnection of the mains must be effected manually.

FIGURE 4 shows a circuit for the reduction of the distortion in the loudspeaker 17, particularly in the resonance region. In this circuit the signal from 20 is applied as one input of a comparator 23, and compared in respect of magnitude and phase (in the region of natural resonance of the loudspeaker) with the audio input signal applied as second input. The result of the comparison produces a correction signal on line 24 which is applied to the amplifier 16 to modify the response of the loudspeaker 17 to the audio input signal. This circuit differs from the previous two in that there is no temporary or permanent signal cut-off, but instead a modification of the signal supplied by the amplifier 16.

The advantage of the invention is that the response to the overload, short-circuit or other detected undesirable condition is very rapid, leading to the quickest possible disconnection of input signal or mains supply, or quickest possible amplifier regulation.

- 6 -

Claims:

1.  A method of controlling the current supplied by a current source through a first conductor to a load, wherein the current in the first conductor is monitored by a second conductor disposed alongside the first so that a current is induced in the second conductor which is proportional to the current in the first conductor, and the supply of current by the current source is controlled in dependence upon the behaviour of the current induced in the second conductor.

2.  A method as claimed in claim 1, wherein the current source is an amplifier and the load is a loudspeaker.

3.  A method as claimed in claim 2, wherein the control is effected in such manner that an input signal to the amplifier is disconnected when the induced current exceeds a preselected threshold.

4.  A method as claimed in claim 2, wherein the control is effected in such manner that the power to the amplifier is disconnected when the induced current exceeds a preselected threshold.

5.  A method as claimed in claim 2, wherein the control is effected in such manner that the characteristics of the amplifier are modified in the region of the resonance frequency of the loudspeaker.

- 7 -

6.   A method substantially as described with reference to FIGURE 2, 3 or 4 of the accompanying drawings.

7.   An apparatus arranged to be operated according to the method of any preceding claim.

Fig. 1.

Fig. 2.

Fig. 3.

Fig. 4.

0007781

European Patent Office

EUROPEAN SEARCH REPORT

Application number

EP 79 30 1438

## DOCUMENTS CONSIDERED TO BE RELEVANT

| Category | Citation of document with indication, where appropriate, of relevant passages | Relevant to claim |
|---|---|---|
| X | US - A - 3 510 790 (TAHMISIAN et al.)<br><br>* Figures 1-4; abstract; column 2, line 58 - column 3, line 5; column 3, lines 58-75; column 4, line 72 - column 5, line 13 *<br><br>-- | 1,4,7 |
| | US - A - 4 092 692 (SMITH et al.)<br><br>* Figures 1-3; column 1, lines 35-45; column 3, lines 3-18; column 4, line 13 - column 6, line 37 *<br><br>-- | 1-3,7 |
| P | US - A - 4 114 108 (FAULKENBERRY)<br><br>* Figure 1; column 2, line 33 - column 3, line 8 *<br><br>---- | 1 |

**CLASSIFICATION OF THE APPLICATION (Int. Cl. ¹)**

G 05 F 1/12
H 03 G 3/20
H 03 F 1/52
H 01 F 19/02

**TECHNICAL FIELDS SEARCHED (Int.Cl. ³)**

H 03 G 3/7
H 03 F 1/52
H 01 F 19/40
G 01 R 1/15
H 02 H
G 05 F 1/12

**CATEGORY OF CITED DOCUMENTS**

X: particularly relevant

A: technological background

O: non-written disclosure

P: intermediate document

T: theory or principle underlying the invention

E: conflicting application

D: document cited in the application

L: citation for other reasons

&: member of the same patent family.

corresponding document

The present search report has been drawn up for all claims

| Place of search | Date of completion of the search | Examiner |
|---|---|---|
| The Hague | 07-11-1979 | GYSEN |

EPO Form 1503.1   06.78